# EUROPEAN PATENT APPLICATION

(11) **EP 2 152 054 A2**
(43) Date of publication of application: **10.02.2010**
(21) Application number: 09002775.6
(22) Date of filing: 26.02.2009
(51) Int. Cl.: H05K 7/20

(54) **Cooling unit, electronic apparatus rack, cooling system, and construction method thereof**

(30) Priority: 08.08.2008 JP 2008205804
(71) Applicant: Hitachi Information & Communication, Kanagawa 244-0003 (JP)
(72) Inventor: Miyazawa, Tomoyuki, Yokohama-shi Kanagawa 220-6122 (JP); Araya, Takeshi, Yokohama-shi Kanagawa 220-6122 (JP); Idei, Akio, Yokohama-shi Kanagawa 220-6122 (JP); Iwata, Hiroshi, Yokohama-shi Kanagawa 220-6122 (JP); Ieta, Kaname, Yokohama-shi Kanagawa 220-6122 (JP); Ebato, Tsuyoshi, Yokohama-shi Kanagawa 220-6122 (JP)
(74) Representative: Strehl Schübel-Hopf & Partner

(57) **Abstract**

A cooling unit which improves the cooling efficiency of a server rack and minimizes rise in the server room temperature. A cooling unit for a server rack housing a server with a heat source includes: a fan unit having an array of fans for discharging hot air generated by the heat source from the rack; and a radiator unit having an array of pipes for guiding coolant to remove heat from the hot air discharged from the rack by rotation of the fans; and a frame unit which integrally combines the fan unit and the radiator unit. The cooling unit constructs a back door from which the hot air inside the rack is discharged.

## Description

### FIELD OF THE INVENTION

The present invention relates to a cooling unit, an electronic apparatus rack, a cooling system and construction methods thereof, and in particular, relates to a cooling panel for cooling a server rack with coolant, a cooling structure of the server rack, a server cooling system and a construction method thereof.

### BACKGROUND OF THE INVENTION

A conventional technique of cooling a server rack is for an example a rack cooling structure disclosed in JP-A No. 2004-63755 in which cold air sent from an air conditioning unit is supplied to an air supply port on a lower part of the rack to cool an apparatus inside the rack and the air heated by the apparatus and discharged from an exhaust port on an upper part of the rack is sent back to the air conditioning unit for circulation.

Furthermore, JP-A No. 2006-93388 discloses a server rack cooling device in which cold air is supplied from a cooler unit through an exchangeable panel to a downflow unit detachably mounted on a front upper part of the inside of a server rack and the downflow unit forces cold air to flow downward to cool an electronic apparatus and waste heat from the cooler unit is discharged through an outdoor exhaust duct to the outside of the room.

In both the techniques described in the above patent documents, the apparatus inside the rack is cooled by blowing cold air to it and it is important to deal with heated air (hot air) inside the rack. In the technique described in JP-A No. 2004-63755, heated air inside the rack is circulated through the air conditioning unit but the room temperature rises due to waste heat discharged from the server and the air conditioning unit. For this reason, an air conditioner for the room must be operated sufficiently to prevent the room temperature from going up. In this approach, the rack cooling efficiency is low and power consumption is unavoidably increased.

In the technique described in JP-A No. 2006-93388, since hot air inside the rack is discharged through the outdoor exhaust duct to the outside of the room, the room temperature does not rise.

However, in both the techniques, the apparatus inside the rack which has become hot is cooled by blowing cold air and the cooling efficiency is not high. Also in these techniques, cold air or hot air or exhaust air is led into the server rack, which necessitates considerable design change in the server rack inner structure and/or change in the location of the electronic apparatus inside the rack or its mounting structure. This leads to a rise in cost.

Because of the need for such design change, these techniques can be applied only to new server rack models and it is difficult to apply the techniques to server racks already installed at customer sites. Therefore, customers who use old models still have no choice but to rely on the conventional cooling method in which the server room is cooled.

### SUMMARY OF THE INVENTION

An object of the present invention is to provide a cooling unit, an electronic apparatus rack, a rack door of the electronic apparatus rack and a cooling system in which improve the cooling efficiency by leading coolant into the cooling unit located in the electronic apparatus rack and a construction method thereof.

Another object of the present invention is to provide a cooling unit which can be attached to an existing electronic apparatus rack and easily attached during operation of the apparatus.

A further object of the present invention is to provide a cooling unit which can be easily attached to an exhaust ventilation side of an electronic apparatus rack depending on apparatus size.

According to an aspect of the present invention, a cooling unit for cooling a rack housing an electronic apparatus with a heat source includes a fan unit having a plurality of fans for discharging hot air generated by the heat source from the rack, and a radiator unit having a plurality of pipes for guiding coolant to remove heat from the hot air discharged from the rack by rotation of the fans. The fan unit and the radiator unit are integrated into a structure.

Preferably the cooling unit further includes a frame unit for holding and fixing the fan unit and the radiator unit integrally. The cooling unit constructs a door of the rack on an exhaust ventilation side thereof and the door has a mounting mechanism for attaching the door to the exhaust ventilation side of the rack in an openable and closable manner.

According to another aspect of the invention, a rack door to be attached to a rack housing an electronic apparatus with a heat source includes a fan unit having an array of fans for discharging hot air generated by the heat source from the rack, a radiator unit having an array of pipes for guiding coolant to remove heat from the hot air discharged from the rack by rotation of the fans, and a mounting mechanism for attaching the door to an exhaust ventilation side of the rack preferably in an openable and closable manner. The fan unit and the radiator unit are integrally combined to construct the door.

According to another aspect of the invention, an electronic apparatus rack housing an electronic apparatus with a heat source, includes: a cooling unit integrally holding and fixing a fan unit and a radiator unit, where the fan unit has a plurality of fans for discharging hot air generated by the heat source from the rack, and the radiator unit has an array of pipes for guiding coolant to remove heat from hot air discharged from the electronic apparatus by rotation of the fans. The cooling unit is attached to an exhaust ventilation side of the rack and coolant is circulated in the pipes to cool the electronic apparatus.

According to another aspect of the invention, a cooling system for cooling a rack housing an electronic apparatus with a heat source includes: a frame unit attached on an exhaust ventilation side of the rack, where the frame unit integrally holds and fixes a fan unit and a radiator unit, the fan unit has an array of fans for discharging hot air generated by the heat source from the rack, and the radiator unit has an array of pipes for guiding coolant to remove heat from the hot air discharged from the electronic apparatus by rotation of the fans; hoses connected to the pipes for circulation of coolant; and a heat exchanger connected to the hoses.

Preferably the heat exchanger is an AW (Air Water) heat exchanger or AC (Air Chiller) heat exchanger.

According to another aspect of the invention, a method for constructing a cooling system for cooling a rack housing an electronic apparatus with a heat source includes the steps of: removing a first door fixed on a prescribed part of the rack housing an electronic apparatus; attaching a second door to the prescribed part in an openable and closable manner, where the second door integrally holds and fixes a fan unit having an array of fans for discharging hot air generated by the heat source from the rack, and a radiator unit having an array of pipes for guiding coolant to remove heat from the hot air discharged from the rack by rotation of the fans; attaching hoses for circulation of coolant to the pipes; and attaching a heat exchanger to the hoses.

In the above method, preferably, the second door matched to the first door's size is prepared and attached.

Furthermore, in the above method, preferably, when the electronic apparatus is in operation, the first door is removed and then the second door is attached.

According to the present invention, by introducing coolant into a cooling unit installed for an electronic apparatus, a higher cooling efficiency is achieved in the cooling unit, electronic apparatus cooling structure and electronic apparatus cooling system.

In addition, the cooling unit can be easily attached to an existing electronic apparatus rack, even when the electronic apparatus is in operation. Also the cooling unit matched to the size of the electronic apparatus can be easily attached on the exhaust ventilation side of the electronic apparatus.

### BRIEF DESCRIPTION OF THE DRAWINGS

Fig. 1 is an exploded perspective view of the cooling structure for a server rack according to an embodiment of the present invention;
Fig. 2 is an exploded perspective view of the structure of a cooling unit 1 according to the embodiment;
Fig. 3 is a back view of the structure of a pipe assembly of a radiator unit 11 according to the embodiment;
Fig. 4 is a front view of the structure of the radiator unit 11 according to the embodiment;
Fig. 5 is a back view of the structure of the radiator unit 11 according to the embodiment;
Fig. 6 is a back view of the structure of a frame unit 12 according to the embodiment;
Fig. 7 is a back view of the structure of a fan unit 13 according to the embodiment;
Fig. 8 is a perspective view of the internal structure of the cooling unit 1 according to the embodiment;
Fig. 9 shows part of a pipe assembly 22 of the radiator unit 11 according to the embodiment; and
Fig. 10 shows an example of a server rack cooling system configuration according to the embodiment.

### DETAILED DESCRIPTION OF THE PREFERRED EMBODIMENTS

Next, an embodiment of the present invention will be described referring to the accompanying drawings.

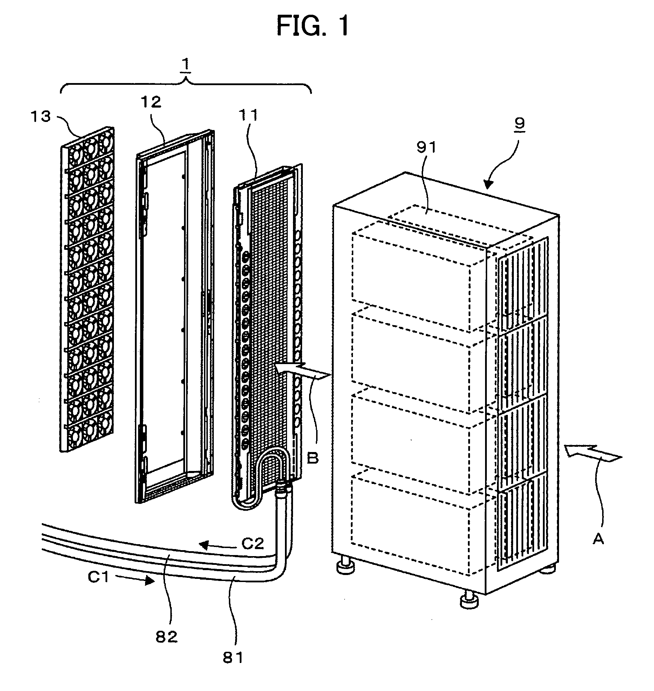

Fig. 1 shows a server rack cooling structure.

A cooling unit 1 is attached to the back of a server rack 9. The server rack 9 houses plural blade servers 91, for example, eight in total on its four shelves with two on each shelf. Each of the blade servers 91 is an electronic apparatus housing electronic components such as a CPU, memory, hard disk and power supply and blower fan where the power supply and memory are heat sources. In the server rack 9, installed in a server room, the blower fan of each blade server takes in cooling air from ahead of the blade server or apparatus (direction indicated by arrow A) and discharges the air heated therein (hot air) through the back of the apparatus (exhaust ventilation side) to the outside of the apparatus (direction indicated by arrow B).

The server rack 9 may have a conventional structure. Originally the conventional server rack 9 had a back door which can be opened and closed for maintenance of the servers, in place of the cooling unit 1. In other words, an outstanding feature of the present invention may be that the back door of the conventional server rack is removed and replaced by a back door with a novel cooling unit 1. If the server rack 9 is a new model, the cooling unit 1 according to this embodiment is an integral part thereof.

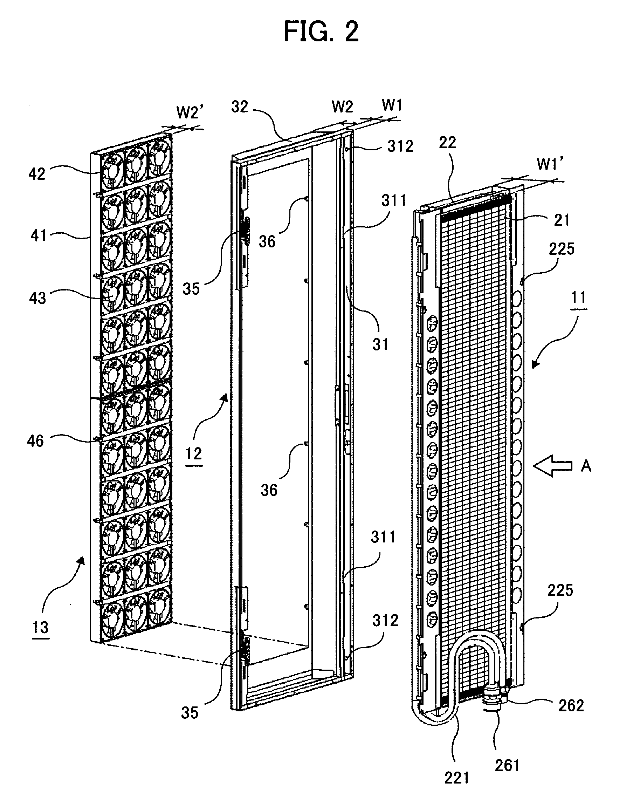

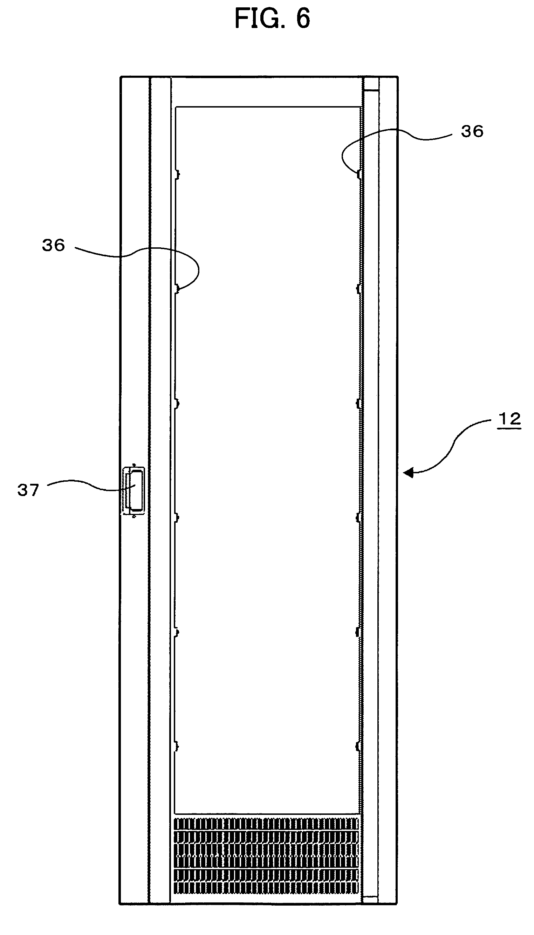

The cooling unit 1 includes a radiator unit 11 for removing the heat from hot air discharged from the back of the rack; a fan unit 13 having many fans (for example, 36 fans or 12 rows by 3 columns) for forcibly discharging hot air; and a frame unit 12 to which the radiator unit 11 and fan unit 13 are integrally attached. That is, the integrally structured cooling unit 1 is constructed as a back door of the server rack 9. Details of these units will be described later referring to Figs. 2 to 8.

The radiator unit 11 has an array of pipes through which coolant (for example, water) circulates. Hoses 81 and 82 through which coolant is passed are connected to ends of the pipes. In the hose 81, the coolant which has not absorbed heat yet flows in the direction indicated by arrow C1 and in the hose 82, the coolant which has absorbed heat flows in the direction indicated by arrow C2.

The structure of the cooling unit 1 will be described in detail referring to Figs. 2 to 8.

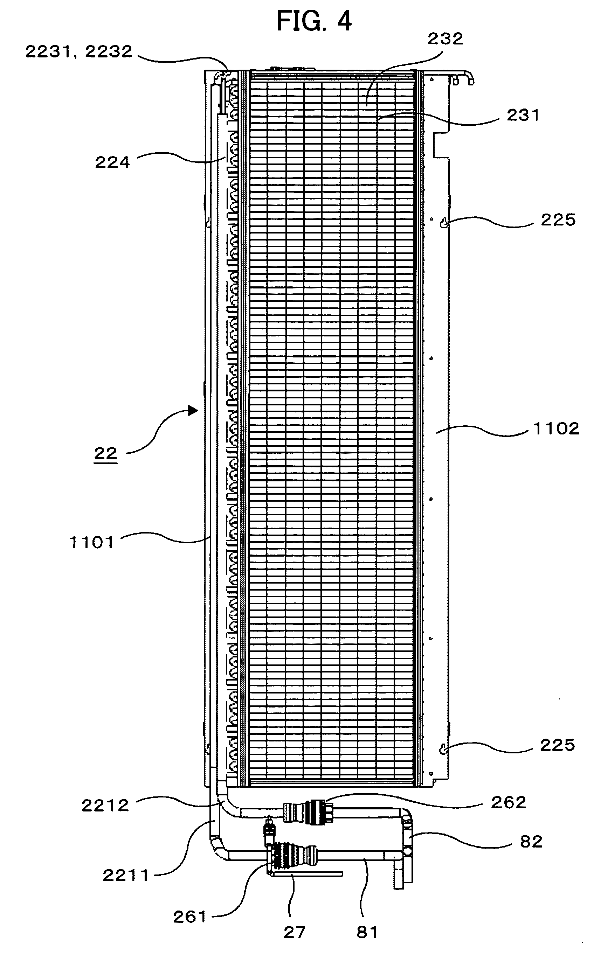

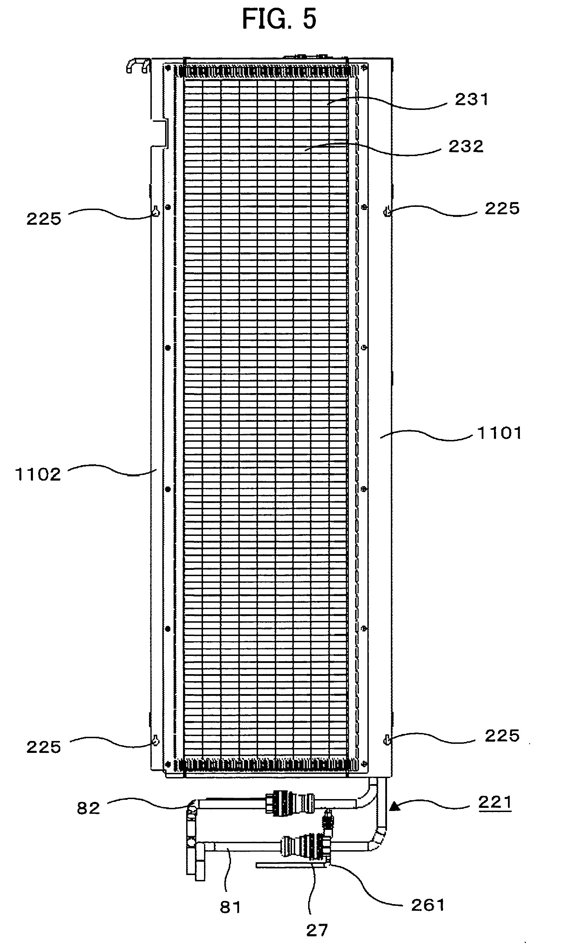

The frame unit 12 with the radiator unit 11 and fan unit 13 integrally attached thereto constructs a back door for cooling which is attached to the server rack 1 located on the right as viewed in Fig. 2. Here, a view taken from the right (server rack) side in Fig. 2 is referred to as a front view (for example, Fig. 4) and a view taken from the left side in Fig. 2 is referred to as a back view (Figs. 5, 6, and 7).

For the sake of easy understanding, the structure of the frame unit 12 will be first described.

As shown in Figs. 2, 6, and 8, the frame unit 12 includes a radiator unit housing frame 31 for housing and holding the radiator unit 11 and a fan frame housing frame 32 for housing and holding the fan unit 13.

The radiator unit housing frame 31 should have enough thickness W1 to house the radiator unit 11 (thickness W1') and the fan frame housing frame 32 should have enough thickness W2 to house the fan unit 13 (thickness W2').

For example, the radiator unit housing frame 31 has four recesses 311 to align with engaging points 225 in frames 1101 and 1102 of the radiator unit 11, and four screw holes 312 for fixing the radiator unit 11 with screws. The fan frame housing frame 32 has, for example, six screwing points 36 on the right and left for fixing the fan unit 13 with screws.

Furthermore, the frame unit 12 includes hinges 35 to attach the back door, an integrated combination of the radiator unit 11 and fan unit 13, to the back of the server rack 9 in an openable and closable manner. The back door attached to the server rack 9 can be opened and closed using a knob 37.

The frame unit 12 is provided with a typical lock mechanism (not shown) and service personnel for the server rack 9 is only allowed to unlock the lock mechanism and open the back door when necessary.

Next, the structure of the radiator unit 11 will be described referring to Figs. 2 to 5 and Figs. 8 and 9.

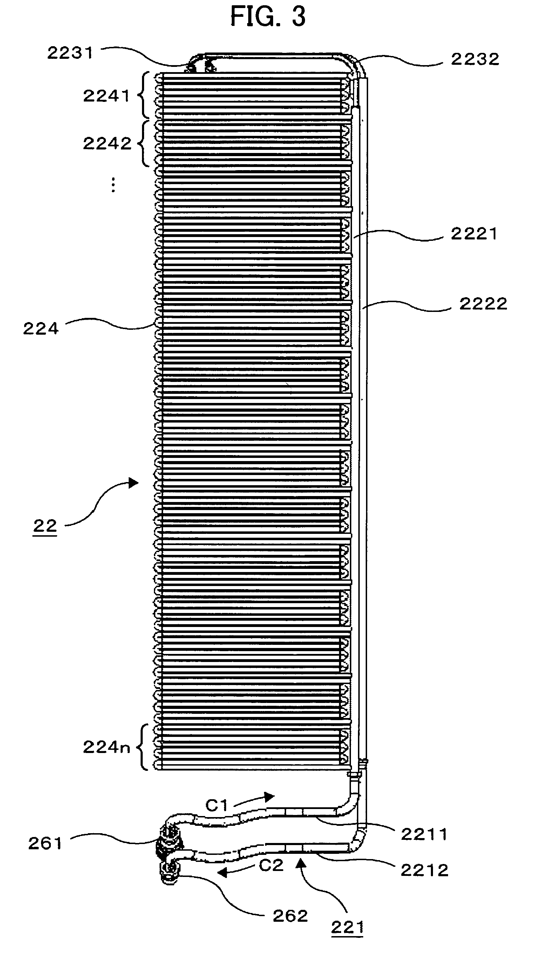

As illustrated in Fig. 2, the radiator unit 11 has a protective panel 21 facing the server rack 9 and a pipe assembly 22 (Fig. 3) located on the inside thereof which are fixed in the frames 1101 and 1102 of the radiator unit 11.

The protective panel 21, intended to protect the pipe assembly 22, is an aluminum plate with many slits on a surface thereof. The hot air discharged from the server rack 9 flows through the slits in the protective panel 21 to the pipe assembly 22.

Figs. 3 to 5 show the structure of the pipe assembly of the radiator unit 11.

Figs. 4 and 5 illustrate the pipe assembly fixed in the frames 1101 and 1102 of the radiator unit 11 (the protective panel 21 is not shown).

The main component of the radiator unit 11 is the pipe assembly 22 as a cluster of folded pipes. The pipe assembly 22 includes a pair of lower pipes 221 for circulation of coolant, a pair of vertical pipes 2221 and 2222 which are connected to the lower pipes 221 and vertically disposed, upper pipes 2231 and 2232 connected to the vertical pipes 2221 and 2222, and horizontal pipes 224 which are connected to the vertical pipes 2221 and 2222 respectively and zigzag-folded and disposed horizontally.

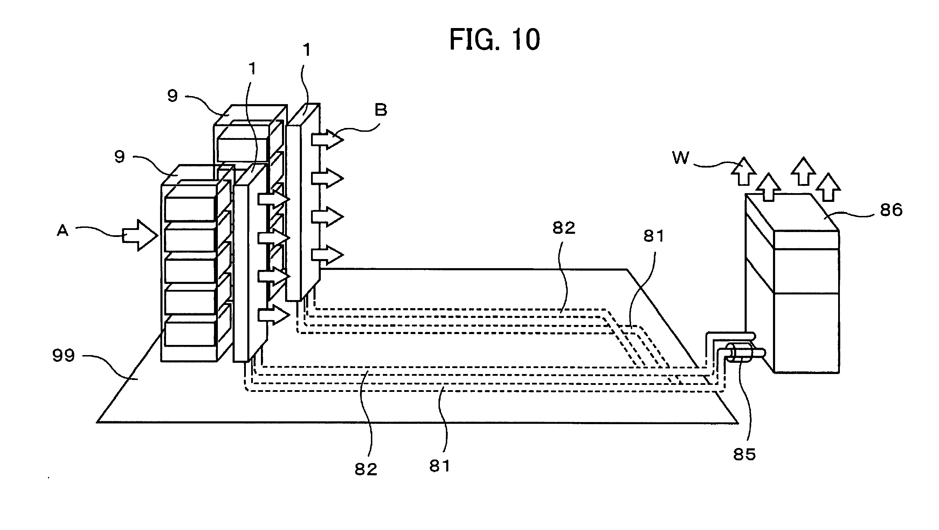

The lower pipe 2211, vertical pipe 2221, and upper pipe 2231 are inflow pipes which allow coolant before heat absorption to flow in the direction indicated by arrow C1. The lower pipe 2212, vertical pipe 2222, and upper pipe 2232 are outflow pipes which allow coolant after heat absorption to flow in the direction indicated by arrow C2. The other ends of the lower pipes 221 are connected to a heat exchanger 86 through hoses (Fig. 10). The coolant in the outflow pipe 2212 which has absorbed heat flows to the heat exchanger 86, thereby constituting a cooling system with coolant circulation.

The pipe assembly 22 is mainly constructed of horizontal pipes 224 as a cluster of pipes and it may be said that the horizontal pipes 224 produce a cooling effect. The horizontal pipes 224 are a pipe cluster having plural horizontal pipe sets 2241 to 224n, each set having three folded pipes. These horizontal pipe sets 2241 to 224n are disposed vertically along the vertical pipes 2221 and 2222 and the pipe ends of each horizontal pipe set are welded to the vertical pipes to construct the pipe assembly 22.

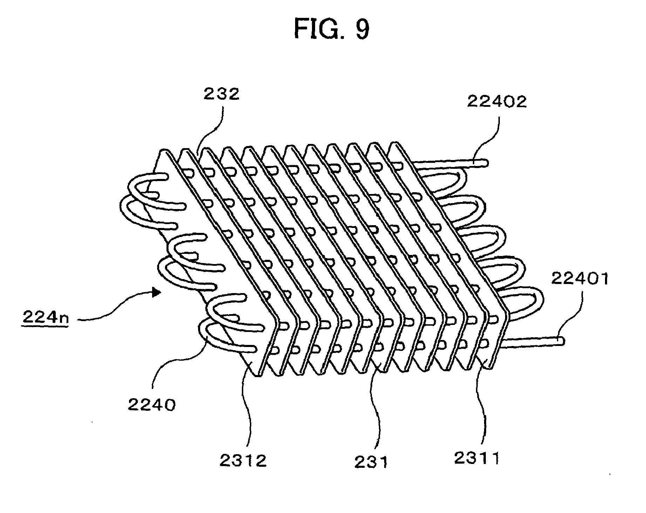

Next, the horizontal pipe sets as components of the pipe assembly 22 will be described referring to Fig. 9.

The horizontal pipe set 224n has plural pipes 2240 passing through holes in many rectangular fins 231 in a row with neighboring U-folded ends of the pipes 2240 welded to each other, thereby constituting a single horizontal pipe. One end 22401 of the pipes 2240 is connected to the vertical pipe 2221 and another end 22402 is connected to the vertical pipe 2222. The fins 231 are made of aluminum which is effective in heat radiation and hot air passes through slits 232 made between fins 231. The identical rectangular fins 231, which are penetrated by the pipes 224n and disposed at regular intervals, not only guide hot air toward a given direction but also support the pipes 224n securely.

The pipe assembly 22 is fitted in the frames 1101 and 1102 by fixing clamps on appropriate points of the pipes (vertical pipes 222*, upper pipes 223*, horizontal pipes 224*).

An alternative approach is that the rightmost fin 2311 and leftmost fin 2312 shown in Fig. 9 also serve as members of the frames 1101 and 1102. If the leftmost and rightmost fins 2311 and 2312 construct the frames 1101 and 1102, the entire pipe assembly 22 is sturdier.

In Fig. 3, the fins 231 are omitted and in Figs. 4 and 5, the fins 231 are represented by vertical lines.

As illustrated in Figs. 4 and 5, a lot of rectangular slits 232 are formed by the fins 231 of the pipe assembly 22 in the radiator unit 11. The fins 231 guide hot air discharged from the server rack 9 toward the pipe assembly 22 by rotation of fans 43 and further guide the hot air passed through the pipe assembly 22 toward the fan unit 13. The fins 231 and slits 232 thus form flow channels for hot air and increase the efficiency of heat absorption by coolant circulating in the pipe assembly 22.

Joints 261 and 262 are fixed to ends of the lower pipes 2211 and 2212 respectively. A hose 81 for circulation of coolant from the heat exchanger 86 (Fig. 10) is connected to the joint 261 and a hose 82 which sends the coolant having absorbed heat to the heat exchanger 86 is connected to the joint 262. An opening/closing lever 27 is provided on the joint 261 to control circulation of the coolant sent through the hose 81.

The length, width and thickness W1' of the radiator unit 11 are such that the radiator unit 11 fits in the radiator unit housing frame 31 of the frame unit 12.

Convex tabs 225 as hooks to be engaged with the recesses 311 of the frame unit 12 are provided, for example, at four places on the rim of the radiator unit 11. These tabs 225 engage with the recesses 311 to fix the radiator unit 11 in the radiator unit housing frame 31 of the frame unit 12.

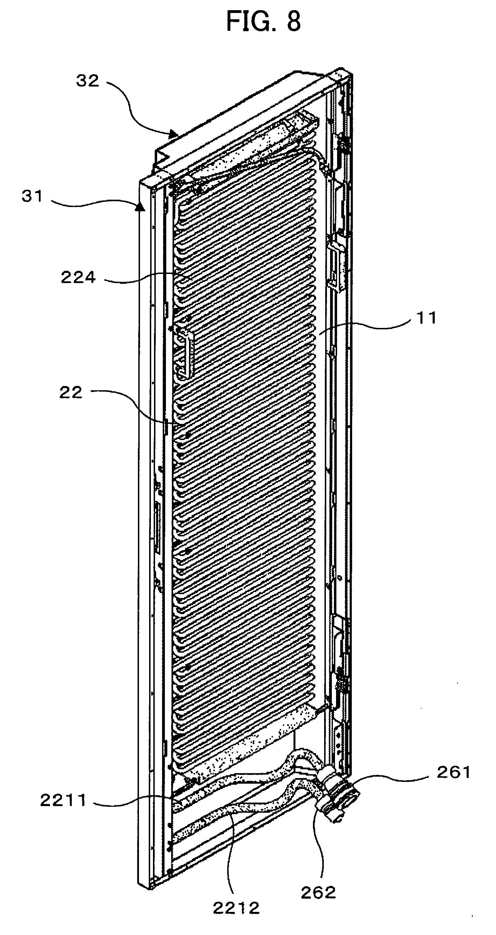

Fig. 8 illustrates the radiator unit 11 fixed in the frame unit 12. In the figure, the protective panel 21 of the radiator unit 11 and the fins 231 of the pipe assembly 22 are omitted so that the inside of the pipe assembly 22 is visible.

Next, the structure of the fan unit will be described.

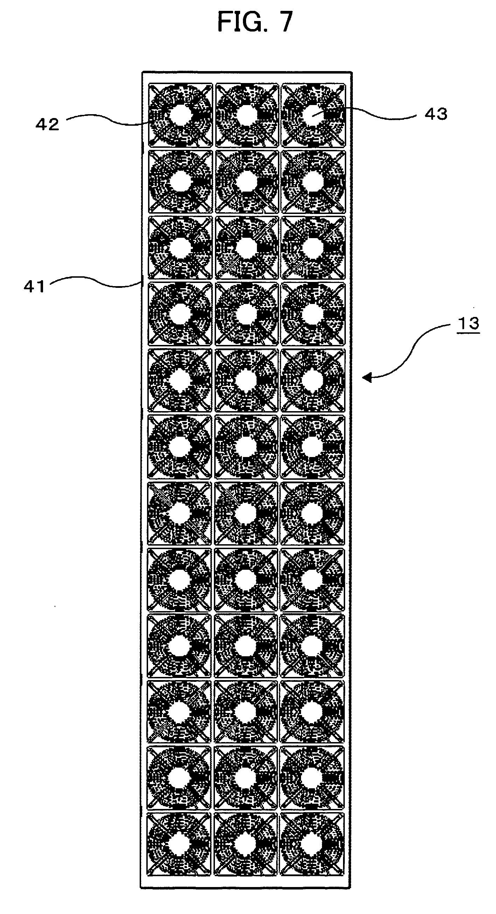

As illustrated in Figs. 2 and 7, the fan unit 13 has an iron fan frame 41 which is divided into thirty-six boxes 42 (twelve rows by three columns), with a fan 43 placed in each box 42. Alternatively the fan frame 41 may include an upper frame 42 and a lower frame 42 which are bonded to each other where eighteen boxes (six rows by three columns) are formed in each of the upper and lower frames. Plural screwing points 46 are provided on the rim of the fan frame 41 to screw the fan unit 13 on mounting points 36 of the frame unit 12. The length, width and thickness W2' of the fan frame 41 are such that the fan frame 41 fits in the fan frame housing frame 32 of the frame unit 12. The screwing points 36 and mounting points 46 are respectively joined by screwing.

As the fans 43 rotate, hot air from the back of the server rack 9 is forced out.

Power cords for power supply to the fans 43 are embedded inside the fan frame 41, though invisible in the figure.

Fig. 10 shows an example of a server rack cooling system configuration.

In this example, two server racks 9 each having a cooling unit 1 are installed in a server room. The server room has a free-access floor 99 and hoses 81 and 82 for circulation of coolant are laid under the floor 99 with one end of each hose connected through a pump 85 to a heat exchanger 86 installed outdoors. The pump 85 is run to force coolant to circulate.

The heat exchanger 86 is an AC (Air Chiller) heat exchanger or AW (Air Water) heat exchanger. If an AC heat exchanger as illustrated is employed, the pump 85 is installed midway on the hose 81 for circulation of coolant and coolant is forced to circulate by operation of the pump. The AC heat exchanger 86 releases the heat of the coolant in the direction indicated by arrows W by rotation of the fan. The AC heat exchanger is expected to produce a cooling effect which is strong enough to cool plural racks at a time.

On the other hand, the AW heat exchanger can be installed in the same room where the server racks to be cooled are installed, though its cooling ability is slightly lower than that of the AC heat exchanger. Since the AW system eliminates the need for outdoor installation work, it is easier to introduce the cooling system than when the AC heat exchanger is employed.

Whether it is the AC system or the AW system, a higher cooling efficiency is ensured than in the conventional server rack cooling system; therefore, electronic apparatuses or electronic components can be mounted densely in the rack. In addition, since both the AC system and AW system can use the same cooling unit 1, even when the AW cooling system is initially employed, it can be easily replaced by the AC system later in order to increase the cooling capacity. Specifically, in this case, the AW heat exchanger 86 should be replaced by the AC heat exchanger.

If another server rack 9 is added to the system shown in the figure, hoses 81' and 82' are connected to the new server rack and the other ends of the hoses are connected to the common hoses 81 and 82.

As explained so far, according to this embodiment, a cooling system with a higher cooling efficiency can be constructed by removing the back door of a conventional server rack and replacing it by a back door as a cooling unit according to this embodiment. In this case, since there is no need to change the arrangement of components mounted inside the conventional server rack, the cooling system can be constructed while the servers are in operation.

Although the amount of generated heat depends on the server rack size and the number of servers housed in the rack, in this embodiment the size of the back door as a cooling unit can be freely changed depending on the size of the server rack to which it is attached. It is also possible to change the number of fans 43 in the fan unit 13 depending on the amount of heat generated by servers. Further, the AW system or AC system can be selected according to the amount of heat generated by servers inside the server rack or the number or capacity of servers installed in the server room. Also, even in the same cooling system, it is possible to cope with change in the number or capacity of servers by altering the heat exchanger capacity.

The present invention is not limited to the above embodiment but it may be embodied in various other forms.

For example, in the above embodiment, the cooling unit is used for the back door of the server rack, but it is not limited thereto. If an electronic apparatus rack is designed to discharge hot air inside it through its top surface or lateral surface, the cooling unit according to this embodiment can be attached to the top or lateral surface. If it is attached to the top surface and need not be openable, it may be attached in a fixed manner.

In the above embodiment, the radiator unit 11 and the fan unit 13 are integrally fitted in the frame unit 12. However, the frame unit 12 may not be a separate unit. For example, the fan frame 41 as the outer frame of the fan unit 13 may be a sturdy structure or a fan frame designed to hold and fix the fan unit instead of the frame unit. Also, if a sturdy frame-like structure for holding and fixing the radiator unit 11 is provided, the structure may be used as the frame unit 12.

The number of fans 43 in the fan unit 13 may be varied as needed. In the case of a large server rack, more fans may be needed and the fan unit 13 shown in Fig. 7 may be larger.

Also the arrangement and number of fans 43 in the fan unit 13 may be varied as needed. If four blade servers are mounted only on the two upper shelves of the server rack 9 shown in Fig. 1, the fan unit 13 need not have as many fans 43 as required to cover the whole back surface of the rack 9 but it may be sufficient that it has only as many fans 43 as required to cover the blade absorbers on the two upper shelves.

In the above embodiment, the cooling unit is applied to server racks which house blade servers. However, it may also be applied to electronic apparatus racks housing electronic apparatuses with heat sources such as disk array devices housing may disk units or communication racks housing plural communication devices.

From the viewpoint of cost, it is desirable to use water as coolant but another kind of coolant may also be used.

## Claims

1. A cooling unit for cooling a rack housing an electronic apparatus with a heat source, comprising:
a fan unit having a plurality of fans for discharging hot air generated by the heat source from the rack; and
a radiator unit having a plurality of pipes for guiding coolant to remove heat from the hot air discharged from the rack by rotation of the fans, the fan unit and the radiator unit being integrated into a structure.

2. The cooling unit according to Claim 1, further comprising:
a frame unit for integrally holding and fixing the fan unit and the radiator unit, wherein the cooling unit constructs a door of the rack on an exhaust ventilation side thereof.

3. The cooling unit according to Claim 1,
wherein said plurality of pipes are mainly zigzag-folded and disposed horizontally and connected to vertical pipes that are connected through a joint to a hose for flowing the coolant therein.

4. The cooling unit according to Claim 1, further comprising:
a plurality of fins that are penetrated by the pipes and disposed at regular intervals for guiding the hot air toward a given direction to the fan unit and supporting the pipes securely.

5. A rack door to be attached to a rack housing an electronic apparatus with a heat source, comprising:
a fan unit having an array of fans for discharging hot air generated by the heat source from the rack;
a radiator unit having an array of pipes for guiding coolant to remove heat from the hot air discharged from the rack by rotation of the fans, the fan unit and the radiator unit being integrally combined to construct the door; and
a mounting mechanism for attaching the door to an exhaust ventilation side of the rack.

6. An electronic apparatus rack housing an electronic apparatus with a heat source, comprising:
a cooling unit integrally holding and fixing a fan unit and a radiator unit, the fan unit having an array of fans for discharging hot air generated by the heat source from the rack, and the radiator unit having an array of pipes for guiding coolant to remove heat from hot air discharged from the electronic apparatus by rotation of the fans,
wherein the cooling unit is attached to an exhaust ventilation side of the rack and coolant is circulated in the pipes to cool the electronic apparatus.

7. The electronic apparatus rack according to Claim 6, wherein the cooling unit constructs a door which is fixed, in an openable and closable manner, to a side of the rack from which the hot air inside the rack is discharged.

8. The electronic apparatus rack according to Claim 6, wherein the cooling unit constructs a back door from which the hot air inside the rack is discharged.

9. A cooling system for cooling a rack housing an electronic apparatus with a heat source, comprising:
the rack with a frame unit attached on an exhaust radiation side of the rack, the frame unit integrally holding and fixing a fan unit and a radiator unit, the fan unit having an array of fans for discharging hot air generated by the heat source from the rack, and the radiator unit having an array of pipes for guiding coolant to remove heat from the hot air discharged from the electronic apparatus by rotation of the fans;
hoses connected to the pipes for circulation of coolant; and
a heat exchanger connected to the hoses.

10. The cooling system according to Claim 9, wherein the heat exchanger is an AW (Air Water) heat exchanger or AC (Air Chiller) heat exchanger.

11. The cooling system according to Claim 9, further comprising:
another rack having a frame unit, a fan unit and a radiator unit of which structure are similar to those of said rack is added to the system and pipes of the another rack are connected via hoses to the heat exchanger.

12. A method for constructing a cooling system for cooling a rack housing an electronic apparatus with a heat source, comprising the steps of:
removing a first door fixed on a prescribed part of the rack housing an electronic apparatus;
attaching a second door to the prescribed part in an openable and closable manner, the second door integrally holding and fixing a fan unit having an array of fans for discharging hot air generated by the heat source from the rack, and a radiator unit having an array of pipes for guiding coolant to remove heat from the hot air discharged from the rack by rotation of the fans;
attaching hoses for circulation of coolant to the pipes; and
attaching a heat exchanger to the hoses.

13. The method for constructing a cooling system according to Claim 12, further comprising the step of preparing the second door matched to the first door's size and attaching the second door.

14. The method for constructing a cooling system according to Claim 12, further comprising the step of, when the electronic apparatus is in operation, removing the first door and then attaching the second door.

15. The method for constructing a cooling system according to Claim 12, the number of fans in the fan unit are changeable depending on the amount of heat generated in the electronic apparatus.
